# EUROPÄISCHE PATENTSCHRIFT

(11) **EP 3 350 650 B1**
(45) Veröffentlichungstag und Bekanntmachung des Hinweises auf die Patenterteilung: **10.03.2021**
(21) Anmeldenummer: 16775076.9
(22) Anmeldetag: 13.09.2016
(51) Int. Cl.: G02F 1/1335, H01L 27/32, G02F 1/13, G09G 3/3208, B32B 3/08, G02F 1/1347, G09G 3/20, G09G 5/00, H04N 5/72, B32B 3/30

(54) **VERFAHREN UND ANORDNUNG ZUR SICHEREN DARSTELLUNG VON INFORMATION**
METHOD AND ARRANGEMENT FOR THE SECURE DISPLAY OF INFORMATION
PROCÉDÉ ET AGENCEMENT PERMETTANT L'AFFICHAGE SÉCURISÉ D'INFORMATIONS

(30) Priorität: 14.09.2015 DE 102015011933
(43) Veröffentlichungstag der Anmeldung: 25.07.2018
(73) Patentinhaber: siOPTICA GmbH, 07745 Jena (DE)
(72) Erfinder: KLIPPSTEIN, Markus, 07751 Jena (DE); SCHWARZ, Jürgen, 99510 Apolda (DE)
(74) Vertreter: Gleim Petri Oehmke Patent- und Rechtsanwaltspartnerschaft mbB
(86) Internationale Anmeldenummer: PCT/EP2016/001538
(87) Internationale Veröffentlichungsnummer: WO 2017/045753

(56) Entgegenhaltungen:
- WO-A1-2014/177342
- WO-A2-2013/048847
- JP-A- 2007 155 784
- US-A1- 2007 153 377

## Beschreibung

### Gebiet der Erfindung

Während in den letzten Jahren bei der Entwicklung von Flachbildschirmen wesentliche Anstrengungen darauf konzentriert wurden, den Sehwinkel für Betrachter zu vergrößern, gibt es oft Situationen, bei denen ein sehr großer Blickwinkelbereich von Nachteil ist, beispielsweise bei der Eingabe von Geheimzahlen auf Bildschirmen von Bankautomaten. Zunehmend werden auch Applikationen für mobile Geräte wie Tablet-PCs oder Mobiltelefone und auch Notebooks verfügbar, mit denen Bankgeschäfte erledigt werden können, oder andere, persönliche Angaben oder sensible Daten angezeigt werden. Insofern ist für die Benutzer solcher Geräte eine Kontrolle des Blickwinkels notwendig, um beispielsweise zu verhindern, dass sensible Daten von beliebigen Dritten wahrgenommen werden können, die sich in dem Blickwinkelbereich aufhalten. Andererseits ist es für eine Vielzahl von anderen Anwendungen, beispielsweise für das Betrachten von stehenden oder bewegten Bildern in der Regel das Ziel, einen möglichst großen Betrachtungswinkel zu haben. Dabei ist es jedoch wünschenswert, für all diese Anwendungen, sensible oder weniger sensible, den gleichen Bildschirm zu verwenden, nicht zuletzt um Kosten zu sparen. Auch bei Bankautomaten oder PIN-Eingabegeräten im Kassenbereich von Geschäften muss nicht für die ganze Zeit der Bildwinkelbereich auf den jeweiligen, davor stehenden Nutzer eingeengt sein, vielmehr kann in den Pausen, in denen das Gerät nicht benutzt wird, der Bildschirm zur Darstellung anderer Informationen oder von Werbung verwendet werden, die von möglichst vielen Personen eingesehen werden sollen.

Insofern ist es also wünschenswert, ein- und dasselbe Gerät sowohl für sensible Vorgänge, bei denen ein enger Blickwinkelbereich notwendig ist, als auch für weniger sensible Anwendungen, bei denen ein möglichst weiter Blickwinkelbereich gewünscht ist, zu verwenden, nicht zuletzt, um den Eigentümern der Geräte Kosten zu ersparen.

### Stand der Technik

Im Stand der Technik existieren dazu verschiedene Ansätze, die jedoch einige Nachteile aufweisen.

So sind seit langem Zusatzfolien bekannt, die auf Mikro-Lamellen basieren. Diese wurden bereits für kleine, mobile Bildschirme eingesetzt, um deren optischen Datenschutz zu verbessern. Allerdings sind solche Folien nicht zwischen einem engen und einem weiten Blickwinkelbereich umschaltbar, vielmehr ist ein händisches Auflegen und Entfernen erforderlich. Auch müssen die Folien getrennt vom Bildschirm transportiert werden, wenn sie für die jeweilige Applikation nicht benötigt werden.

In der US 6,765,550 B2 wird ein verbesserter, auf Mikro-Lamellen basierender Sichtschutz beschrieben. Hier ist jedoch die Handhabung des Filters, der jeweils mechanisch, d.h. von Hand angebaut oder entfernt werden muss, nachteilig. Zudem ist der Lichtverlust im geschützten Modus sehr hoch, so dass dieser Sichtschutz in Umgebungen mit hoher Helligkeit kaum eingesetzt werden kann. Die weitere, vermittels Polarisationsdrehung beschriebene, eingebaute und elektrische Umschaltung zwischen einem öffentlichen und einem privaten Modus verdunkelt das Bild stark, da dieser Aufbau deutlich mehr optisch wirksame Schichten erfordert.

In der US 6,211,930 B1 wird der Einsatz eines zweiten LC-Bildschirms mit Sichtschutz für Bankautomaten beschrieben. Die rückwärtige Beleuchtung, das Backlight wird dabei so kollimiert, dass nur durch das Ausschalten eines zwischengeschalteten Diffusors Licht durch diese Anordnung gelangt. Auch hier ist der technische Aufwand und sind die damit verbundenen Kosten hoch. Auf Grund der Diffusorwirkung geht außerdem die Helligkeit im öffentlichen Modus sehr stark nach unten.

In der WO 2012/033583 A1 wird die Umschaltung zwischen freier und eingeschränkter Sicht mittels der Ansteuerung von Flüssigkristallen zwischen sogenannten "chromonischen" Schichten erzeugt. Ähnlich wie bei den vorab beschriebenen Folien ist hier jedoch der Lichtverlust sehr hoch, zudem ist die technische Realisierung recht aufwändig und kostenintensiv.

In der JP 2005-134678 A wird ein Bildschirm beschrieben, bei dem mittels der Ansteuerung von Flüssigkristallen zwischen einem öffentlichen und einem nicht-öffentlichen Modus umgeschaltet werden kann. Diese Lösung ist jedoch kostenintensiv. Zudem tritt, wie bei den anderen bereits genannten Ansätzen, ein großer Helligkeitsverlust ein.

Die WO 2015/121398 A1 der Anmelderin beschreibt ein Verfahren zur Umschaltung zwischen einem öffentlichen und einem privaten Sichtmodus, bei der Licht von der Hintergrundbeleuchtung in einen nicht eingeschränkten bzw. einen eingeschränkten Winkel abgestrahlt wird. Davor befindet sich ein LCD-Panel. Während diese Lösung für LCD-Panels attraktiv ist, kann sie für selbstleuchtende Displays wie etwa OLEDs keine Lösung anbieten.

Die US 2014/0226093 A1 beschreibt die Umschaltung zwischen einem öffentlichen und einem privaten Sichtmodus vermittels Lamellen, die mit PDLC-Flüssigkristallen gefüllt sind, welche zwischen einem streuenden und einem transparenten Modus umschalten können. Diese Lösung funktioniert auch mit selbstleuchtenden Displays. Nachteilig ist hierbei, dass PDLC-Kristalle relativ hohe Wechselspannungen von einigen 10 Volt benötigen, um in den transparenten Modus zu schalten. Es entsteht ein permanenter Stromverbrauch für den öffentlichen Modus. Darüber hinaus sind, um genügend starke Streuwirkungen für den privaten Modus zu erzielen, gewisse PDLC-Dicken anzusetzen. Diese wiederum ergeben im transparenten Modus eine Schwächung des durchgehenden Lichtes, weswegen in dieser Ausgestaltung mit sichtbaren, den Bildeindruck störenden Strukturen auf dem Bildschirm zu rechnen ist.

Weiterhin offenbart die US 2015 / 0138457 A1 einen autostereoskopischen Bildschirm und ein Anwendungsverfahren desselben. Dabei können über definierbare Sichtzonen (Winkelbereiche im Raum) Sichtschutzeffekte erzielt werden. Hierzu wird ein Linsenraster verwendet, welches Licht von einer Bildwiedergabeeinrichtung in den Raum abbildet. Zwischen diesen beiden Komponenten ist eine weitere Komponente zur selektiven Lichtabschattung angeordnet, um die Raumwinkelbereiche auswählen zu können. Nachteilig ist hierbei insbesondere die Auflösungsverminderung auf Grund der Linsenwirkungen.

Die Schrift US 2013 / 0050798 A1 offenbart einen schaltbaren Privacyfilter und dessen Herstellung. Hierbei wird eine Elektrolytflüssigkeit in lamellenartige Kammern gefüllt, um zwischen einem Privacy- und einem freien Sichtmodus umzuschalten. Nachteilig sind hierbei der hohe Herstellungsaufwand sowie der Lichtverlust.

In der US 2014 / 0327705 A1 wird ein Bildschirm beschrieben, der mittels einer optischen Komponente in einen Sichtschutzmodus geschaltet werden kann. Dazu werden die in einen seitlichen Raumbereich abgestrahlten Informationen durch Störlicht überlagert und somit nicht wahrnehmbar gestaltet. Hierzu ist jedoch die optische Komponente hinter der Bildwiedergabeeinrichtung anzuordnen, was in vielen Fällen nicht praktikabel ist

Die WO2014/177342, WO2013/048847, JP2007155784 A beschreiben weitere Beispiele mit einem öffentlichen und einem privaten Sichtmodus.

Bei den im Stand der Technik bekannten Verfahren und Anordnungen führt die Bereitstellung der Möglichkeit einer Umschaltung zwischen einem privaten, geschützten Modus mit eingeengtem Blickwinkelbereich und einem öffentlichen, ungeschützten Betriebsmodus mit einem weiten Blickwinkelbereich in der Regel dazu, dass die Helligkeit des Grundbildschirms deutlich reduziert wird und/oder das Verfahren nicht für selbstleuchtende Displayarten anwendbar ist und/oder ein zusätzlicher Stromverbrauch in einem der beiden Modi oder sogar in beiden Modi anfällt. Zudem ist meistens die Herstellung technisch aufwendig und damit kostenintensiv.

### Beschreibung der Erfindung

Aufgabe der Erfindung ist es daher, Verfahren und Anordnung zur sicheren Darstellung von Information zu entwickeln, die in Serie kostengünstig umsetzbar sein sollen. Darüber hinaus soll vorteilhaft die Helligkeit des Grundbildschirms kaum oder nicht reduziert werden, der technische Ansatz auch für selbstleuchtende Displayarten anwendbar sein, und höchstens ein vernachlässigbarer zusätzlicher Stromverbrauch in beiden Betriebsmodi anfallen.

Die Aufgabe der Erfindung wird erfindungsgemäß gelöst von einem Verfahren zum Betreiben eines Bildschirms nach Anspruch 1.

So ist es zum Beispiel möglich, dass jede zweite, dritte, vierte, fünfte, zehnte oder vorzugsweise auch jede Lamelle derartige ansteuerbare Schichten beinhaltet, welche transparent oder selbst (hell) leuchtend geschaltet werden können.

In der Betriebsart B2 ist mit "hell leuchtend" gemeint, dass die Leuchtdichte auf den ansteuerbaren Schichten wenigstens 30%, bevorzugt mehr als 80%, besonders bevorzugt über 100% der Leuchtdichte eines weißen Bildes auf dem Bildschirm entspricht.

Die besagten ansteuerbaren Schichten können beispielsweise transparente OLEDs beinhalten, aber auch andere, zwischen transparent oder selbstleuchtend umschaltbare Schichten, wie z.B. elektrolumineszente Schichten.

Die Wirkungsweise der Erfindung ist dann für die Betriebsart B1, dass die Lamellen allesamt transparent sind und diese so die Sicht aus schrägen Blickrichtungen auf den Bildschirm nicht versperren. In der Betriebsart B2, wenn die Lamellen leuchten, blockieren diese den Blick auf den Bildinhalt des Bildschirms in entsprechenden Blickwinkel außerhalb von α durch Überlagerung des vom Bildschirm zur Seite hin abgestrahlten Lichtes mit Licht aus den Lamellen, weil dieses fast ausschließlich beim Blick von der Seite sichtbar ist.

Bevorzugt stehen die Lamellen senkrecht, also in einem Winkel von 90 Grad, zur Oberfläche des Bildschirms. Dieser Winkel bestimmt wesentlich, aus welchem zentralen Winkel man im eingeschränkten Sichtmodus B2 noch ein Bild sehen kann.

Weiterhin können vorteilhaft diejenigen Lamellen, welche keine der besagten ansteuerbaren Schichten beinhalten, statt dessen passive Lichtstreumittel enthalten, die bei Beleuchtung mit Licht von den ansteuerbaren Schichten dieses Licht streuen und selbiges mindestens teilweise seitlich vor den Bildschirm abstrahlen, wobei der Haze dieser passiven Lichtstreumittel kleiner 4%, bevorzugt kleiner 2% gemessen nach ASTM D1003 beträgt. Es ist wichtig, dass die passiven Lichtstreumittel transparent sind, wenn kein Licht auf Sie fällt, d.h. dass sie geringen Haze aufweisen, weil nur so die Betriebsart B1 möglich wird.
Als Materialien für die passiven Lichtstreumittel kommen beispielsweise Titandioxidpartikel einer mittleren Partikelgröße von 150 - 500 nm in einer Konzentration bezogen auf das Gewicht der jeweiligen Lamelle von 0.01 - 300 Gew.-ppm in Frage. Andere Ausgestaltungen sind möglich, etwa mit Partikeln aus Bariumsulfat, mit silsesquioxanen Partiken oder mit vernetzten Polystyrol-Partikeln oder noch anderen Arten von Partikeln. Die Streupartikel sind in der Regel homogen innerhalb der jeweiligen Lamellen verteilt.
Es ist auch möglich, dass die passiven Lichtstreumittel jeweils aus einem Matrixkunststoff A und darin verteilten Streupartikeln aus einem Polymerisat B bestehen, wobei der Anteil der Streupartikel bestehend aus Polymerisat B jeweils 0,01 bis 3 Gewichtsprozent bezogen auf den Matrixkunststoff A beträgt, und die Brechzahl nD(B) des Polymerisats B um mindestens 0,002 Einheiten über der Brechzahl nD(A) des Matrixkunststoffs A liegt.
Ferner können die passiven Lichtstreumittel mindestens 40 Gew.%, bevorzugt mindestens 60 Gew. %, Polymethylmethacrylat bezogen auf ihr (Teil-)Gewicht, beinhalten.

Überdies können auch in jeweils einer einzigen Lamelle selbst teilflächig ansteuerbare Schichten und an anderen Teilflächen passive Lichtstreumittel enthalten sein.

Die Höhe einer Lamelle kann beispielsweise zwischen 50µm und 500µm, ggf. auch größer oder kleiner, variieren. Sie hängt vom jeweiligen gewünschten Betrachtungsabstand in der Betriebsart B2 ab. Die Wandstärken der Lamellen können z.B. zwischen 10µm und 50 µm oder größer betragen. Der durchschnittliche Abstand von Lamellenmitte zu Lamellenmitte entspricht in etwa der einfachen bis höchstens zehnfachen Größenordnung der Lamellenwandstärke. Die Dimensionierung liegt im fachmännischen Können und wird daher hier nicht weiter beschrieben.

Schließlich ist es auch möglich, zwei separate zueinander, bevorzugt im Winkel von 90°, gekreuzte Lagen von Lamellen vor dem Bildschirm anzuordnen. Damit wird in der Betriebsart B2 der Sichtschutz nicht nur gleichzeitig in zwei Richtungen, z.B. links und rechts, sondern in vier Richtungen, also gleichzeitig links/rechts und oben/unten erreicht. Dies ist besonders wichtig für Zahlterminalfunktionen, um geeignete Zertifizierungstests zu bestehen.

Entsprechende Ansteuerelektroniken für den Bildschirm und für die schaltbaren Schichten sind selbstredend vorhanden.

Der Bildschirm kann beispielsweise ein LCD-Bildschirm, ein OLED-Bildschirm oder ein FED-Bildschirm sein. Andere Ausgestaltungen sind möglich, insbesondere auch mit anderen Arten von selbstleuchtenden Displays.

Schließlich kann jeweils zwischen benachbarten Lamellen optisch transparentes Material als Füllmaterial angeordnet sein, beispielsweise bestehend aus optischem Gießharz, aus UV-härtendem Material oder aus Plexiglas. Damit wird eine stabile Bauweise erzielt.

Die Aufgabe der Erfindung wird auch gelöst von einer Anordnung zur sicheren Darstellung von Bildinhalten nach Anspruch 6.

So ist es zum Beispiel möglich, dass jede zweite, dritte, vierte, fünfte, zehnte oder auch jede Lamelle ansteuerbare Schichten beinhaltet, welche transparent oder selbst hell leuchtend geschaltet werden können. In der Betriebsart B2 ist mit "hell leuchtend" gemeint, dass die Leuchtdichte auf den ansteuerbaren Schichten wenigstens 30%, bevorzugt mehr als 80%, besonders bevorzugt über 100% der Leuchtdichte eines weißen Bildes auf dem Bildschirm entspricht.

Die besagten ansteuerbaren Schichten können beispielsweise transparente OLEDs beinhalten, aber auch andere, zwischen transparent oder selbstleuchtend umschaltbare Schichten, wie z.B. elektrolumineszente Schichten.
Die Wirkungsweise der Erfindung ist dann für die Betriebsart B1, dass die Lamellen allesamt transparent sind und diese so die Sicht auf den Bildschirm nicht versperren. In der Betriebsart B2, wenn die Lamellen leuchten, blockieren diese den Blick auf den Bildinhalt des Bildschirms in entsprechenden Blickwinkel außerhalb von α durch Überlagerung des vom Bildschirm zur Seite hin abgestrahlten Lichtes mit Licht aus den Lamellen, weil dieses fast ausschließlich beim Blick von der Seite sichtbar ist.

Bevorzugt stehen die Lamellen senkrecht, also in einem Winkel von 90 Grad, zur Oberfläche des Bildschirms. Dieser Winkel bestimmt wesentlich, aus welchem zentralen Winkel man im eingeschränkten Sichtmodus B2 noch ein Bild sehen kann.
Die Lamellen sind vorzugsweise auf einem transparenten Substrat (z.B. Glass oder PMMA) angeordnet.

Weiterhin können vorteilhaft diejenigen Lamellen, welche keine der besagten ansteuerbaren Schichten beinhalten, statt dessen passive Lichtstreumittel enthalten, die bei Beleuchtung mit Licht von den ansteuerbaren Schichten dieses Licht streuen und selbiges mindestens teilweise seitlich vor den Bildschirm abstrahlen, wobei der Haze dieser passiven Lichtstreumittel kleiner 4%, bevorzugt kleiner 2% gemessen nach ASTM D1003 beträgt. Es ist wichtig, dass die passiven Lichtstreumittel transparent sind, wenn kein Licht auf Sie fällt, d.h. dass sie geringen Haze aufweisen, weil nur so die Betriebsart B1 möglich wird.
Als Materialien für die passiven Lichtstreumittel kommen beispielsweise Titandioxidpartikel einer mittleren Partikelgröße von 150 - 500 nm in einer Konzentration bezogen auf das Gewicht der jeweiligen Lamelle von 0.01 - 300 Gew.-ppm in Frage. Andere Ausgestaltungen sind möglich, etwa mit Partikeln aus Bariumsulfat, mit silsesquioxanen Partiken oder mit vernetzten Polystyrol-Partikeln oder noch anderen Arten von Partikeln. Die Streupartikel sind in der Regel homogen innerhalb der jeweiligen Lamellen verteilt.
Es ist auch möglich, dass die passiven Lichtstreumittel jeweils aus einem Matrixkunststoff A und darin verteilten Streupartikeln aus einem Polymerisat B bestehen, wobei der Anteil der Streupartikel bestehend aus Polymerisat B jeweils 0,01 bis 3 Gewichtsprozent bezogen auf den Matrixkunststoff A beträgt, und die Brechzahl nD(B) des Polymerisats B um mindestens 0,002 Einheiten über der Brechzahl nD(A) des Matrixkunststoffs A liegt.
Ferner können die passiven Lichtstreumittel 6 mindestens 40 Gew.%, bevorzugt mindestens 60 Gew. %, Polymethylmethacrylat bezogen auf ihr (Teil-)Gewicht, beinhalten.

Überdies können auch in jeweils einer einzigen Lamelle selbst teilflächig ansteuerbare Schichten und an anderen Teilflächen passive Lichtstreumittel enthalten sein.

Die Höhe einer Lamelle kann beispielsweise zwischen 50µm und 500µm, ggf. auch größer oder kleiner, variieren. Sie hängt vom jeweiligen gewünschten Betrachtungsabstand in der Betriebsart B2 ab. Die Wandstärken der Lamellen können z.B. zwischen 10µm und 50 µm oder größer betragen. Der durchschnittliche Abstand von Lamellenmitte zu Lamellenmitte entspricht in etwa der einfachen bis höchstens zehnfachen Größenordnung der Lamellenwandstärke. Andre Abmessungen sind möglich. Die Dimensionierung liegt im fachmännischen Können und wird daher hier nicht weiter beschrieben.

Schließlich ist es auch möglich, zwei separate zueinander, bevorzugt im Winkel von 90°, gekreuzte Lagen von Lamellen vor dem Bildschirm anzuordnen. Damit wird in der Betriebsart B2 der Sichtschutz nicht nur gleichzeitig in zwei Richtungen, z.B. links und rechts, sondern in vier Richtungen, also gleichzeitig links/rechts und oben/unten erreicht. Dies ist besonders wichtig für Zahlterminalfunktionen, um geeignete Zertifizierungstests zu bestehen.

Entsprechende Ansteuerelektroniken für den Bildschirm und für die schaltbaren Schichten sind selbstredend vorhanden.

Der Bildschirm kann beispielsweise ein LCD-Bildschirm, ein OLED-Bildschirm oder ein FED-Bildschirm sein. Andere Ausgestaltungen sind möglich, insbesondere auch mit anderen Arten von selbstleuchtenden Displays.

Schließlich kann jeweils zwischen benachbarten Lamellen optisch transparentes Material als Füllmaterial angeordnet sein, beispielsweise bestehend aus optischem Gießharz, aus UV-härtendem Material oder aus Plexiglas. Damit wird eine stabile Bauweise erzielt.

Weiterhin ist es möglich, dass die ansteuerbaren Schichten Licht nur auf einer Großfläche abstrahlen, dies kann z.B. mit transparenten OLEDs umgesetzt werden. Damit wäre in der Betriebsart B2, wenn gewünscht, ein Sichtschutz nur in eine Richtung umsetzbar. Schließlich können die Lamellen auch so konfiguriert sein, dass nur eine teilflächige Umschaltung zwischen den Betriebsarten B1 und B2 für den Bildschirm erzielt wird.

Die Erfindung umfasst ebenso die Verwendung des erfindungsgemäßen Verfahrens zum Betreiben eines Bildschirms oder eines erfindungsgemäßen Bildschirms zur Eingabe von vertraulichen Daten im Modus B2.

Nachfolgend wird die Erfindung sowie beispielhafte Verfahren anhand der beigefügten Zeichnungen, die auch wesentliche Merkmale offenbaren, noch näher erläutert. Es zeigt:
Fig. 1 eine Umsetzung des erfindungsgemäßen Verfahrens im Modus B1,
Fig. 2 eine Umsetzung des erfindungsgemäßen Verfahrens im Modus B2, sowie
Fig. 3 eine Umsetzung des erfindungsgemäßen Verfahrens im Modus B2, hier mit einer anderen Ausgestaltung der Lamellen.

Die Zeichnungen sind sämtlich rein schematisch und nicht maßstäblich.

Das erfindungsgemäße Verfahren zum Betreiben eines Bildschirms 1 in mindestens zwei Betriebsarten B1 für einen freien Sichtmodus und B2 für einen eingeschränkten Sichtmodus, umfasst die Merkmale des Anspruchs 1.

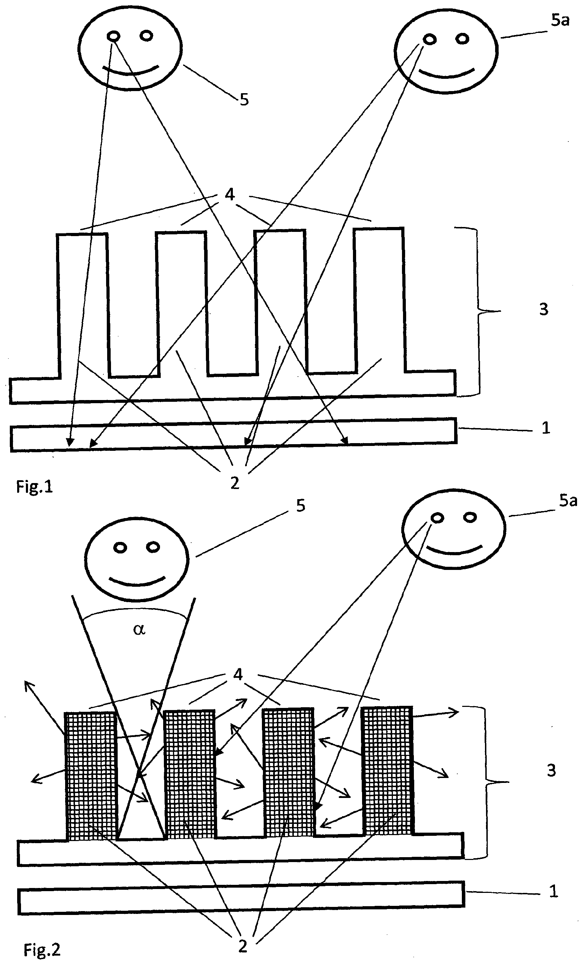

In diesem Beispiel nach Fig.1 beinhaltet jede Lamelle 4 ansteuerbare Schichten 2, welche transparent oder selbst hell leuchtend geschaltet werden können. Die besagten ansteuerbaren Schichten 2 sind hier beispielsweise als transparente OLEDs umgesetzt, so dass diese zwischen einem transparenten und einem selbstleuchtenden Zustand umgeschaltet werden können.

Die Fig.1 zeigt eine Umsetzung dieses erfindungsgemäßen Verfahrens im Modus B1. Die Wirkungsweise der Erfindung ist in dieser Betriebsart B1, dass die Lamellen 4 allesamt transparent sind (weil die ansteuerbaren Schichten 2 transparent geschaltet sind) und diese so die Sicht auf den Bildschirm 1 für alle Betrachter 5 und 5a aus allen Blickrichtungen nicht versperren.

Fig. 2 hingegen stellt eine Umsetzung des erfindungsgemäßen Verfahrens im Modus B2 dar. In dieser Betriebsart B2, wenn die Lamellen 4 leuchten, weil die ansteuerbaren Schichten 2 im selbstleuchtenden Zustand befindlich sind, blockieren diese den Blick für einen Betrachter 5a auf den Bildinhalt des Bildschirms 1 in entsprechenden Blickwinkel außerhalb von α durch Überlagerung des vom Bildschirm 1 zur Seite hin abgestrahlten Lichtes mit Licht aus den Lamellen 4 (siehe Pfeilstriche in Fig.2, die aus den Lamellen 4 ragen), weil dieses fast ausschließlich beim Blick von der Seite, z.B. aus der Sichtposition des Betrachters 5a, sichtbar ist. Für den Betrachter 5 gibt es keine Sichteinschränkung, solange er sich im Winkel α aufhält. Dies kann in der Zeichnung Fig.1 nur bedingt wiedergegeben werden, da bei richtigem Dimensionsverhältnis der Betrachter 5 deutlich weiter oberhalb des Bildschirms 1 eingezeichnet werden müsste, was aus Platzgründen nicht möglich ist.

Bevorzugt stehen die Lamellen 4 senkrecht, also in einem Winkel von 90 Grad, zur Oberfläche des Bildschirms 1. Dieser Winkel bestimmt wesentlich, aus welchem zentralen Winkel man im eingeschränkten Sichtmodus B2 noch ein Bild sehen kann.

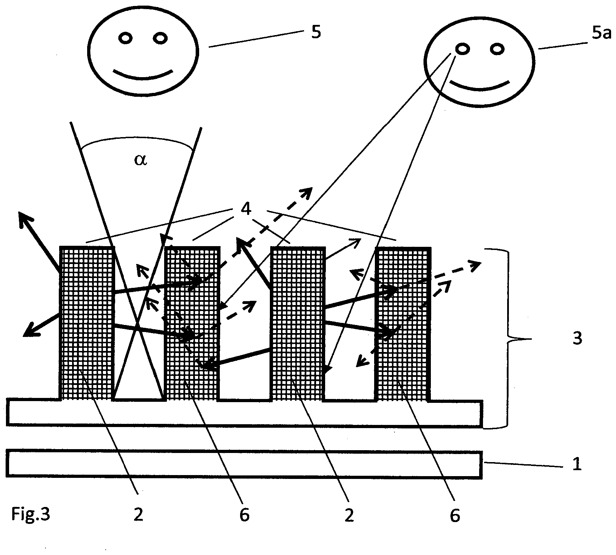

Die Fig.3 zeigt nun eine Ausgestaltung in der Betriebsart B2, bei der nur jede zweite Lamelle 4 ansteuerbare Schichten 2 beinhaltet, welche transparent oder selbst hell leuchtend geschaltet werden können. Die anderen Lamellen 4, welche keine der besagten ansteuerbaren Schichten 2 beinhalten (also jede andere zweite Lamelle 4), enthalten statt dessen passive Lichtstreumittel 6, die bei Beleuchtung mit Licht (siehe durchgezogene Pfeillinien in Fig.3) von den ansteuerbaren Schichten 2 dieses Licht streuen und selbiges mindestens teilweise seitlich vor den Bildschirm 1 abstrahlen (siehe gestrichelte Pfeillinien in Fig.3), wobei der Haze dieser passiven Lichtstreumittel 6 kleiner 4%, bevorzugt kleiner 2% gemessen nach ASTM D1003 beträgt. Insgesamt bewirkt dann die Gesamtheit aller Lamellen 4 dann wie weiter oben beschrieben den Sichtschutz, indem das von den Lamellen ausgehende Licht das Licht von dem Bildschirm zu Seitenwinkeln hin derart überlagert, dass der dargestellte Bildinhalt für einen Betrachter 5a nicht mehr wahrnehmbar ist. Ein Betrachter 5 kann hingegen das Bild nahezu unbeeinflusst wahrnehmen, da senkrecht zum Bildschirm 1 kein oder nahezu kein Licht abgestrahlt wird. Hierzu können die Lamellen 4 an ihrer dem Betrachter 5 zugewandten Seite noch opake Linien, die die Lamellen 4 aus Sichtrichtung abschließen und somit in Betrachtungsrichtung den Lichtaustritt verhindern, beinhalten.

Es ist wichtig, dass die passiven Lichtstreumittel 6 transparent sind, wenn kein Licht auf Sie fällt, d.h. dass sie geringen Haze aufweisen, weil nur so die Betriebsart B1 möglich wird.
Als Materialien für die passiven Lichtstreumittel 6 kommen beispielsweise Titandioxidpartikel einer mittleren Partikelgröße von 150 - 500 nm in einer Konzentration bezogen auf das Gewicht der jeweiligen Lamelle von 0.01 - 300 Gew.-ppm in Frage. Andere Ausgestaltungen sind möglich, etwa mit Partikeln aus Bariumsulfat, mit silsesquioxanen Partiken oder mit vernetzten Polystyrol-Partikeln oder noch anderen Arten von Partikeln. Die Streupartikel sind in der Regel homogen innerhalb der jeweiligen Lamellen 4 verteilt.
Ferner können die passiven Lichtstreumittel 6 mindestens 40 Gew.%, bevorzugt mindestens 60 Gew. %, Polymethylmethacrylat bezogen auf ihr (Teil-)Gewicht, beinhalten.
Die Höhe einer Lamelle 4 kann beispielsweise zwischen 50µm und 500µm, ggf. auch größer oder kleiner, variieren. Sie hängt vom jeweiligen gewünschten Betrachtungsabstand in der Betriebsart B2 ab. Die Wandstärken der Lamellen 4 können z.B. zwischen 10µm und 50 µm oder größer betragen. Der durchschnittliche Abstand von Lamellenmitte zu Lamellenmitte entspricht in etwa der einfachen bis höchstens zehnfachen Größenordnung der Lamellenwandstärke. Andere Abmessungen sind möglich. Die Dimensionierung liegt im fachmännischen Können und wird daher hier nicht weiter beschrieben.
Entsprechende Ansteuerelektroniken für den Bildschirm 1 und für die schaltbaren Schichten 2 sind selbstredend vorhanden.
Der Bildschirm 1 kann beispielsweise ein LCD-Bildschirm, ein OLED-Bildschirm oder ein FED-Bildschirm sein. Andere Ausgestaltungen sind möglich, insbesondere auch mit anderen Arten von selbstleuchtenden Displays.
Schließlich kann jeweils zwischen benachbarten Lamellen 4 optisch transparentes Material als Füllmaterial angeordnet sein, beispielsweise bestehend aus optischem Gießharz, aus UV-härtendem Material oder aus Plexiglas. Damit wird eine stabile Bauweise erzielt.

Die vorstehenden Erläuterungen zu den Zeichnungen Fig1. bis Fig.3 können sinngemäß auch für die erfindungsgemäße Anordnung angewendet werden. Diese werden aus Redundanzgründen hier nicht wiederholt.
Mit dem vorstehend beschriebenen erfindungsgemäßen Verfahren und der erfindungsgemäßen Anordnung ist es möglich, sicherheitsrelevante Informationen auf Wunsch nur in einem kleinen Blickwinkelbereich darzustellen, so dass sie nur von der adressierten Person wahrgenommen werden können, wohingegen nicht sicherheitsrelevante Informationen so in voller Auflösung des Bildschirms dargestellt werden können, dass sie aus einem weiten Blickwinkelbereich und damit auch von Dritten, nicht beteiligten Personen eingesehen werden können.
Die Erfindung löst die gestellte Aufgabe: Es wurden ein Verfahren und eine Anordnung zur sicheren Darstellung von Informationen vorgeschlagen, die in Serie kostengünstig umsetzbar sind. Darüber hinaus wird vorteilhaft die Helligkeit des Grundbildschirms kaum oder nicht reduziert, der technische Ansatz ist auch für selbstleuchtende Displayarten anwendbar und es fällt in allen Ausgestaltungen der Erfindung ein vernachlässigbarer zusätzlicher Stromverbrauch in beiden Betriebsmodi an. Auch die Umschaltung zwischen den Betriebsmodi B1 und B2 erfordert sehr wenig Energie.

## Patentansprüche

1. Verfahren zum Betreiben eines Bildschirms (1) in mindestens zwei Betriebsarten B1 für einen freien Sichtmodus und B2 für einen eingeschränkten Sichtmodus, umfassend die folgenden Schritte
- Anordnung eines schaltbaren optischen Elements (3), welches die Umschaltung zwischen den mindestens zwei Betriebsarten B1 und B2 gewährleistet, in Betrachtungsrichtung eines Betrachters (5) unmittelbar vor einem Bildschirm (1),
- Darstellung eines Bildinhaltes auf dem Bildschirm (1),
- wobei das optische Element (3) eine Vielzahl von Lamellen (4) enthält, und
- wobei wenigstens jede zwanzigste Lamelle (4) ansteuerbare Schichten (2) beinhaltet, welche zwischen einem transparenten und einem selbstleuchtenden, hellen Zustand umgeschaltet werden können, wodurch die optische Wirkung der Lamellen (4) zwischen transparent (B1) und selbst hell leuchtend (B2) änderbar ist.

2. Verfahren nach Anspruch 1, **dadurch gekennzeichnet, dass** die besagten ansteuerbaren Schichten (2) transparente OLEDs und/oder elektrolumineszente Schichten beinhalten.

3. Verfahren nach Anspruch 1 oder 2, **dadurch gekennzeichnet, dass** diejenigen Lamellen (4), welche keine der besagten ansteuerbaren Schichten (2) beinhalten, statt dessen passive Lichtstreumittel (6) mit einem Haze kleiner 4%, bevorzugt kleiner 2% gemessen nach ASTM D1003 enthalten, die bei Beleuchtung mit Licht von den ansteuerbaren Schichten (2) dieses Licht streuen und selbiges mindestens teilweise seitlich vor den Bildschirm (1) abstrahlen.

4. Verfahren nach einem der vorgenannten Ansprüche, **dadurch gekennzeichnet, dass** der Bildschirm (1) ein LCD-Bildschirm, ein OLED-Bildschirm oder ein FED-Bildschirm ist.

5. Verfahren nach einem der vorgenannten Ansprüche, **dadurch gekennzeichnet, dass** jeweils zwischen benachbarten Lamellen (4) optisch transparentes Material als Füllmaterial angeordnet ist, beispielsweise bestehend aus optischem Gießharz, aus UV-härtendem Material oder aus Plexiglas.

6. Anordnung zur sicheren Darstellung von Bildinhalten, die in mindestens zwei Betriebsarten B1 für einen freien Sichtmodus und B2 für einen eingeschränkten Sichtmodus betrieben werden kann, umfassend:
- einen Bildschirm (1),
- ein schaltbares optisches Element (3), welches die Umschaltung zwischen den mindestens zwei Betriebsarten B1 und B2 gewährleistet, und welches in Betrachtungsrichtung eines Betrachters (5) unmittelbar vor dem Bildschirm (1) angeordnet ist,
- wobei das optische Element (3) eine Vielzahl von Lamellen (4) enthält, wobei wenigstens jede zwanzigste Lamelle (4) ansteuerbare Schichten (2) beinhaltet, welche so ausgelegt sind, dass sie zwischen einem transparenten und einem selbstleuchtenden, hellen Zustand umgeschaltet werden können, wodurch die optische Wirkung der Lamellen (4) zwischen transparent (B1) und selbst hell leuchtend (B2) änderbar ist.

7. Anordnung nach Anspruch 6, **dadurch gekennzeichnet, dass** die besagten ansteuerbaren Schichten (2) transparente OLEDs und/oder elektrolumineszente Schichten beinhalten.

8. Anordnung nach Anspruch 6 oder 7, **dadurch gekennzeichnet, dass** diejenigen Lamellen (4), welche keine der besagten ansteuerbaren Schichten (2) beinhalten, statt dessen passive Lichtstreumittel (6) mit einem Haze kleiner 4%, bevorzugt kleiner 2% gemessen nach ASTM D1003 enthalten, die bei Beleuchtung mit Licht von den ansteuerbaren Schichten (2) dieses Licht streuen und selbiges mindestens teilweise seitlich vor den Bildschirm (1) abstrahlen.

9. Anordnung nach einem der Ansprüche 6 bis 8, **dadurch gekennzeichnet, dass** der Bildschirm (1) ein LCD-Bildschirm, ein OLED-Bildschirm oder ein FED-Bildschirm ist.

10. Verwendung des Verfahrens zum Betreiben eines Bildschirms (1) oder einer Anordnung nach einem der vorgenannten Ansprüche zur Eingabe von vertraulichen Daten im Modus B2 für einen eingeschränkten Sichtmodus.

## Claims

1. A method of operating a screen (1) in at least two operating modes, B1 for a free viewing mode and B2 for a restricted viewing mode, said method comprising the steps of
- arranging, directly in front of a screen (1) in the viewing direction of an observer (5), a switchable optical element (3) that ensures switching between the at least two operating modes B1 and B2,
- Displaying an image content on the screen (1),
- wherein the optical element (3) comprises a plurality of lamellae (4), and
- wherein at least every twentieth lamella (4) includes controllable layers (2) which can be switched between a transparent and a bright, self-luminous state, whereby the optical effect of the lamellae (4) is changeable between transparent (B1) and brightly self-luminous (B2).

2. The method according to claim 1, **characterised in that** said controllable layers (2) comprise transparent OLEDs and/or electroluminescent layers.

3. The method according to claim 1 or 2, **characterised in that** those lamellae (4) which do not contain any of said controllable layers (2) instead contain passive light scattering means (6) with a Haze value of less than 4%, preferably less than 2%, measured according to ASTM D1003, which, when illuminated with light from the controllable layers (2), scatter said light and radiate it at least partially sideways in front of the screen (1).

4. The method according to any one of the preceding claims, **characterised in that** the screen (1) is an LCD screen, an OLED screen or an FED screen.

5. The method according to any one of the preceding claims, **characterised in that** optically transparent material is disposed as a filler between adjacent lamellae (4) in each case, said material consisting of, for example, optical casting resin, UV-curing material or acrylic glass.

6. An arrangement for securely displaying image contents, which arrangement can be operated in at least two operating modes, B1 for a free viewing mode and B2 for a restricted viewing mode, said arrangement comprising:
- a screen (1),
- a switchable optical element (3), which ensures switching between the at least two operating modes B1 and B2 and which is arranged directly in front of the screen (1) in the viewing direction of an observer (5),
wherein the optical element (3) includes a plurality of lamellae (4), at least every twentieth lamella (4) including controllable layers (2) which are designed to be switchable between a transparent and a bright, self-luminous state, whereby the optical effect of the lamellae (4) is changeable between transparent (B1) and brightly self-luminous (B2).

7. The arrangement according to claim 6, **characterised in that** said controllable layers (2) comprise transparent OLEDs and/or electroluminescent layers.

8. The arrangement according to claim 6 or 7, **characterised in that** those lamellae (4) which do not contain any of said controllable layers (2) instead contain passive light scattering means (6) with a Haze value of less than 4%, preferably less than 2%, measured according to ASTM D1003, which, when illuminated with light from the controllable layers (2), scatter said light and radiate it at least partially sideways in front of the screen (1).

9. The arrangement according to any one of claims 6 to 8, **characterised in that** the screen (1) is an LCD screen, an OLED screen or an FED screen.

10. Use of the method for operating a screen (1) or an arrangement according to any one of the preceding claims for entering confidential data in mode B2, which is a restricted viewing mode.

## Revendications

1. Procédé pour faire fonctionner un écran (1) selon au moins deux modes de fonctionnement, à savoir B1 pour un mode de visualisation illimité et B2 pour un mode de visualisation limité, ledit procédé comprenant les étapes suivantes:
- disposition d'un élément optique commutable (3), qui assure la commutation entre les au moins deux modes de fonctionnement B1 et B2, directement devant un écran (1) dans la direction d'observation d'un observateur (5),
- affichage d'un contenu d'image sur l'écran (1),
- dans lequel l'élément optique (3) comprend une pluralité de lamelles (4), et
- au moins une lamelle (4) sur vingt comprenant des couches contrôlables (2) qui peuvent être commutées entre un état de transparence et un état de forte luminescence, l'effet optique des lamelles (4) pouvant être modifié entre un effet transparent (B1) et un effet fortement luminescent (B2).

2. Procédé selon la revendication 1, **caractérisé en ce que** lesdites couches contrôlables (2) comprennent des OLED transparents et/ou des couches électroluminescentes.

3. Procédé selon la revendication 1 ou 2, **caractérisé en ce que** les lamelles (4) qui ne contiennent aucune desdites couches contrôlables (2) contiennent, au lieu desdites couches, des moyens passifs de diffusion de lumière (6) avec une valeur Haze inférieure à 4%, de préférence inférieure à 2%, mesurée selon la norme ASTM D1003, qui, lorsqu'ils sont éclairés par la lumière des couches contrôlables (2), diffusent cette lumière et la rayonnent au moins partiellement latéralement devant l'écran (1).

4. Procédé selon l'une quelconque des revendications précédentes, **caractérisée en ce que** l'écran (1) est un écran LCD, un écran OLED ou un écran FED.

5. Procédé selon l'une des revendications précédentes, **caractérisé en ce qu'**un matériau optiquement transparent est disposé comme matériau de remplissage entre des lamelles (4) voisines dans chaque cas, par exemple constitué d'une résine de coulée optique, d'un matériau durcissant aux UV ou de verre acrylique.

6. Ensemble pour l'affichage sécurisé de contenus d'images, qui peut être exploité dans au moins deux modes de fonctionnement : B1 pour un mode de visualisation illimité et B2 pour un mode de visualisation limité, comprenant :
- un écran (1),
- un élément optique commutable (3), qui assure la commutation entre les au moins deux modes de fonctionnement B1 et B2 et qui est disposé directement devant l'écran (1) dans la direction d'observation d'un observateur (5),
dans lequel ledit élément optique (3) comprend une pluralité de lamelles (4), au moins une lamelle (4) sur vingt comprenant des couches contrôlables (2) qui sont configurées de manière à pouvoir être commutées entre un état de transparence et un état de forte luminescence, l'effet optique des lamelles (4) pouvant être modifié entre un effet transparent (B1) et un effet fortement luminescent (B2).

7. Ensemble selon la revendication 6, **caractérisé en ce que** lesdites couches contrôlables (2) comprennent des OLED transparents et/ou des couches électroluminescentes.

8. Ensemble selon la revendication 6 ou 7, **caractérisé en ce que** les lamelles (4) qui ne contiennent aucune desdites couches contrôlables (2) contiennent, au lieu desdites couches, des moyens passifs de diffusion de lumière (6) avec une valeur Haze inférieure à 4%, de préférence inférieure à 2%, mesurée selon la norme ASTM D1003, qui, lorsqu'ils sont éclairés par la lumière des couches contrôlables (2), diffusent cette lumière et la rayonnent au moins partiellement latéralement devant l'écran (1).

9. Ensemble selon l'une quelconque des revendications 6 à 8, **caractérisé en ce que** l'écran (1) est un écran LCD, un écran OLED ou un écran FED.

10. Utilisation de la méthode de fonctionnement d'un écran (1) ou d'un ensemble selon l'une quelconque des revendications précédentes pour la saisie de données confidentielles en mode B2 qui est un mode de visualisation limité.
